# EUROPÄISCHE PATENTSCHRIFT

(11) **EP 0 467 076 B1**
(45) Veröffentlichungstag und Bekanntmachung des Hinweises auf die Patenterteilung: **07.02.1996**
(21) Anmeldenummer: 91109849.9
(22) Anmeldetag: 15.06.1991
(51) Int. Cl.: G03F 7/20

(54) **Verfahren und Vorrichtung zur Herstellung von Mikrostrukturen auf einem lichtempfindlich beschichteten Substrat durch fokussierte Laserstrahlung**
Method and apparatus for fabricating microstructures on a photosensitively layered substrate by means of focussed laser radiation
Procédé et appareil pour la fabrication de microstructures sur un substrat à couches photosensibles par radiation laser focalisée

(30) Priorität: 17.07.1990 DE 4022732
(43) Veröffentlichungstag der Anmeldung: 22.01.1992
(73) Patentinhaber: MICRONIC LASER SYSTEMS AB, S-18303 Täby (SE)
(72) Erfinder: Thurén, Anders, S-18372 Täby (SE); Sandström, Torbjörn, S-43543 Mölnlycke (SE)
(74) Vertreter: Nöth, Heinz, Dipl.-Phys.

(56) Entgegenhaltungen:
- GB-A- 2 215 553
- US-A- 4 549 222
- SOLID STATE TECHNOLOGY, Band 30, Nr. 8, August 1987, Port Washington, NY, USA; Seiten 59-61; J.C. MCMENAMIN: "Laser technology in photolithography"

## Beschreibung

Die Erfindung betrifft ein Verfahren und eine Vorrichtung zur Herstellung, von Mikrostrukturen auf einem mit einer lichtempfindlichen Schicht beschichteten Substrat. Durch fokussierte Laserstrahlung wird ein Flächenmuster, insbesondere Struktur sowie insbesondere eine Struktur aus Chrom auf Glas, welche als Maske oder Reticle für die Photolitographie bei der Halbleiterherstellung verwendet wird, hergestellt.

Masken und sogenannte Reticles mit äußerst genauen Strukturen aus Chrom auf Glasunterlagen werden für die Herstellung photolitographischer Strukturen in der Halbleiterherstellung verwendet. Ein 5fach-Reticle, d. h. eine Struktur, welche auf den Halbleiter-Wafer fünffach photographisch verkleinert wird und in naher Zukunft den wohl am meisten üblichen Maskentyp verkörpert, kann aus einer Quarzplatte mit einer Abmessung von 150 mm x 150 mm bestehen, die eine Struktur aus lichtundurchlässigem Chrom aufweist. Die Struktur wird gebildet durch 3elichtung mit Licht oder einem Elektronenstrahl eines licht- bzw. elektronenempfindlichen Überzugs, der einen Chromfilm bedeckt. Der licht- bzw. elektronenempfindliche Überzug wird dann chemisch entwickelt und der belichtete Teil entfernt. Bei einem anschließenden Ätzvorgang wird das Chrom an den Stellen des entfernten Überzugs weggeätzt, und der verbleibende Chromfilm bildet die Struktur.

Die geringsten Linienbreiten bekannter 5fach-Reticles betragen etwa 2 Mikron. Die geforderte Genauigkeit ist jedoch beträchtlich höher. Zulässige Overlay-Fehler, d. h. die zulässige Differenz zwischen der Lage der Chromkanten in zwei aufeinanderfolgenden Schritten hergestellten identischen Reticles ist in der Größenordnung von 0,05 Mikron.

Reticles finden in der Halbleiterherstellung ihre Hauptanwendung für die Herstellung genauer Strukturen. Es sind jedoch noch viele andere Anwendungsmöglichkeiten vorhanden, beispielsweise auf dem Gebiet der integrierten Optik, der Beugungsoptik, computererzeugter Hologramme, der Mikrobearbeitung von miniaturisierten Sensoren, optischer Informationsspeicherung und von supraleitenden Einrichtungen. Die hohen Kosten vorhandener Herstelleinrichtungen für Flächenmuster bzw. Strukturen mit ausreichender Genauigkeit, insbesondere von Elektronenstrahl-Reticleschreibern, stellt eine Hürde dar für die Entwicklung neuer Geräte auf diesen weniger entwickelten Gebieten, insbesondere in Universitäten und kleineren Firmen.

Allen bekannten Pattern-Generatoren ist gemeinsam, daß die Maske bzw. das Reticle in einer digitalen Datenbank beschrieben ist. Diese Datenbank enthält eine Liste aller Strukturelemente mit ihren geometrischen Daten.

Vor dem Schreiben der Strukturen werden die geometrischen Daten auf das durch die schreibende Hardware verwendete Format umgesetzt. Während dieser Umsetzung werden die geometrischen Koordinaten auf die adressierende Auflösung der Hardware, d. h. auf das schreibende Adreßraster, zugeschnitten.

Ein dabei auftretender Approximationsfehler von 0,25 Mikron, der durch ein Adreßraster von 0,5 Mikron erzeugt wird, ist akzeptabel, wenn die Struktur mit diesem Adressenraster gebildet wird und niemals reskaliert wird. Jedoch bewirken Operationen, wie beispielsweise eine gleichförmige Skalierung einer Struktur durch beispielsweise 93 %, einen vorgegebenen Prozeßfehlerbereich (beispielsweise eine Erhöhung der Abmessung aller Elemente zur Kompensation von zu geringem Ätzen während des Prozeßablaufs) von beispielsweise 0,15 Mikron oder eine Verlagerung der Struktur bzw. Flächenmusters um einen zusätzlichen Abstand, unvorhersehbare Approximationsfehler, die in der Struktur erscheinen.

Ein Adressenraster, welches fein genug ist, um den Approximationsfehler bedeutungslos zu machen, ist erforderlich, damit diese Operationen bzw. Verfahrensschritte möglich sind. Ein feineres Raster ermöglicht ferner, daß die Struktur unabhängig von der verwendeten Maschine, mit welcher die Struktur geschrieben wird, hergestellt werden kann. Dies ist erwünscht, da die Gestaltung und die Herstellung der Maske in unterschiedlichen Herstellungsstätten stattfindet. In bevorzugter Weise soll der Approximationsfehler geringer als 0,05 Mikron für 5fach- Reticles sein.

Die meisten modernen Pattern-Generatoren verwenden ein Rasterscan-Prinzip mit einem Scan-Strahl, der entweder ein Elektronenstrahl oder Laserstrahl ist, der entlang paralleler Linien bzw. Zeilen auf dem Substrat, das mit einem strahlungsempfindlichen Überzug bedeckt ist, abgelenkt wird. Der Strahl wird ein- und ausgeschaltet in Abhängigkeit von einer Bitkarte (Bitmap) für die Struktur, die im Kontrollsystem gespeichert ist. Eine andere Möglichkeit besteht darin, daß der Strahl während einer Schreibzeit erzeugt wird, die aus Daten abgeleitet wird, welche in einem verdichteten Zwischenformat gespeichert sind.

Für eine Struktur (Flächenmuster) mit einem Adressenraster von 0,5 Mikron läßt sich eine Bitkarte mit einem Bit für jeden Rasterpunkt herstellen. Normale Schreibgeschwindigkeiten liegen bei 5 bis 10 Quadratmillimeter pro Sekunde. Dies entspricht einer angemessenen Datengeschwindigkeit von 20 bis 40 Mbit pro Sekunde mit einem Datenvolumen von 10 bis 100 Gigabyte pro Maske. Mit Hilfe eines geeigneten Datenverdichtungsalgorithmusses ist es möglich, die verdichteten Daten auf einer Festplatte zu speichern und zur Schreibzeit auf das volle Datenvolumen zu expandieren. Ferner ist die Datengeschwindigkeit verträglich mit herkömmlich verwendeten Familien von integrierten Schaltungen und im Handel erhältlichen elektro-optischen und akusto-optischen Modulatoren.

Im Prinzip könnte ein Muster mit einer Adressierbarkeit von 0,05 Mikron auch mit Scan-Zeilen im Abstand von 0,05 Mikron und einem Pixelabstand von 0,05 Mikron entlang der Scan-Zeile geschrieben werden. Jedoch entspricht eine Bitkarte mit einen 0,05 Mikron-Raster und einem oben erwähnten Flächendurchsatz einer Datengeschwindigkeit von 2 - 4 Gbit pro Sekunde. Die Modulation eines einzelnen Schreibstrahls mit dieser Geschwindigkeit ist nicht möglich. Außerdem ist das Datenvolumen hundertmal größer als für das 0,5 Mikron-Raster und ist ziemlich unhandbar. Selbst eine Realzeitexpandierung vom verdichteten Datenformat ist nicht praktikabel, da der Datenfluß die Datenbusleitungen der meisten Prozessoren verstopfen wurde. Technologische Begrenzungen bei der Modulationsgeschwindigkeit und dem Datenfluß wurden die Schreibgeschwindigkeit beträchtlich einschränken und einen Reticle-Schreiber mit einer vollen Pixelmap mit 0,05 Mikron-Adressenraster nicht anwendbar machen.

Es ist bekannt, Masken und Reticles mit Hilfe einer Laserscaneinrichtung zu erzeugen (US-PS 4 060 816). Diese bekannte Einrichtung ist jedoch zu langsam für beispielsweise eine praktische Anwendung bei der Maskenherstellung.

Das einfache mechanische Scanning in X- und Y-Richtung führt zu einem ungeeigneten Durchsatz, und es ist bekannt, daß ein Sub-Scan-Prinzip zur Erhöhung der Schreibgeschwindigkeit verwendet werden kann (US-PS 4 455 485).

Ferner ist es bekannt (GB-PS 2 215 553), daß man ein feineres Adressierraster mit einem festen groben Schreibraster erhalten kann, wenn die Oberfläche mehrere Male abgetastet wird. Aufeinanderfolgende geschriebene Raster können mit geringer Verlagerung übereinandergelegt werden, so daß die Dichte des sich ergebenden Rasters erhöht wird. Als weitere Möglichkeit zur Verbesserung der Adressierauflösung wird mehrere Male mit einer jedesmal modifizierten Bitkarte geschrieben, so daß einige Bildelemente zweimal geschrieben werden und andere Bildelemente nur einmal geschrieben werden. Da der Brennpunktfleck größer ist als der Abstand zwischen den Bildelementen, ist die Belichtung eine glatte Funktion, die die einzelnen Bildelemente überdeckt. Ein Strukturelement besitzt Kanten, von denen aus die Belichtung von Null bis zur vollen Belichtung glatt ansteigt. Das Hinzufügen einer Reihe von Pixel mit halber Intensität hat die Wirkung der Verschiebung des Intensitätsprofils um einen halben Pixelabstand. Durch viermaliges Schreiben eines 0,5 Mikron-Rasters, wobei zweimal die ursprüngliche Position und zweimal eine um 0,25 Mikron versetzte Positionierung gewählt wird, erzielt man ein effektives Adressierraster von 0,125 Mikron gemäß dem Verfahren nach der GB-PS 2 215 553. Hierbei ergibt sich ein effektives Adressierraster, das um das Vierfache geringer ist als das Hardwareraster; jedoch benötigt man vier über die Oberfläche geführte Schreibdurchgänge.

Es ist ferner bekannt, daß bei Videowiedergaben Bildelemente an Pixelbruchteilen positioniert werden können unter Verwendung der sogenannten "Antialiasing"-Technik (IEEG CG + A, Januar 1981, Seiten 40 bis 48). Das Bild, welches aus einer digitalen Datenbank erzeugt werden kann, wird an fiktiven Sub-Pixelpositionen abgetastet. Die abgetasteten Subpixeldaten werden über mehrere wirkliche Pixel hin geglättet, und die geglätteten, d. h. ausgebreiteten Daten von jedem Subpixel werden an den wirklichen Pixelpositionen addiert. Das Auge interpretiert diese hieraus resultierenden verschwommenen Übergänge als scharfe Kanten, und die in Erscheinung tretende Position von Kanten kann in kleine bruchstückhafte Bildelementzunahmen durch Modifizierung der Dosis an den Pixelstellen geändert werden.

Ferner ist es bekannt, daß die Runlänge-Codierung (RLE) ein geeigneter Datenverdichtungsalgorithmus für Bildelementdaten, die lange Folgen von einzelnen Werten enthalten, ist. Das Volumen der verdichteten Daten ist eine Funktion hauptsächlich der Anzahl der Übergänge von einem Wert zu einem anderen und zurück und hängt in geringem Umfang von der Bitmap-Auflösung ab.

Aufgabe der Erfindung ist es, eine Struktur der eingangs genannten Art sowie ein Verfahren und eine Vorrichtung zu ihrer Herstellung mit Hilfe eines fokussierten Laserstrahls zu schaffen, bei dem eine erhebliche Erhöhung der Rasterauflösung ohne Beeinträchtigung der Schreibgeschwindigkeit und guter Kantenqualität bei handhabbaren Datenvolumen erreicht wird.

Diese Aufgabe wird verfahrensmäßig durch den Gegenstand des Anspruchs 1 und vorrichtungsmäßig durch den Gegenstand des Anspruchs 16 gelöst. Die Unteransprüche kennzeichnen Weiterbildungen der Erfindung.

In vorteilhafter Weise läßt sich durch die Erfindung eine Verbesserung der Rasterauflösung um einen Faktor 4 und mehr ohne Beeinträchtigung der Schreibgeschwindigkeit erreichen. Die Kantenabweichung ist geringer als bei der bloßen "Antialiasing"-Technik, und das Datenvolumen besitzt einen handhabbaren Umfang.

Im Hinblick auf die Erhöhung der Dichte von Adressierpunkten hat sich herausgestellt, daß eine Erhöhung der Dichte der Scan-Zeilen einen nicht annehmbaren Aufwand an Schreibzeit erfordert. In der Praxis sind sowohl die Scan-Geschwindigkeit als auch die maximale Modulationsfrequenz des Laserstrahls begrenzt. Eine Verdoppelung der Scan-Zeilendichte wurde eine Verdoppelung der Scan-Geschwindigkeit und eine Verdoppelung der Anzahl der pro Sekunde zu schreibenden Pixel erforderlich machen. In Richtung entlang der Scan-Zeile ist eine Verringerung des Pixelabstands um mindestens das Vierfache, insbesondere Fünf- und Achtfache, nicht allzu schwerwiegend, da ein dichteres Adressierraster lediglich einen geringen Zeitzuwachs zwischen den Rasterpunkten bedeutet. Mit ungeänderter minimaler Strukturgröße im Flächenmuster bleibt die Schaltfrequenz des Modulators unbeeinflußt. Die Schwierigkeit liegt in dem größeren Datenvolumen zur Spezifizierung einer Struktur mit einem dichteren Raster.

Die Figuren dienen zur Erläuterung der Erfindung. Es zeigen:

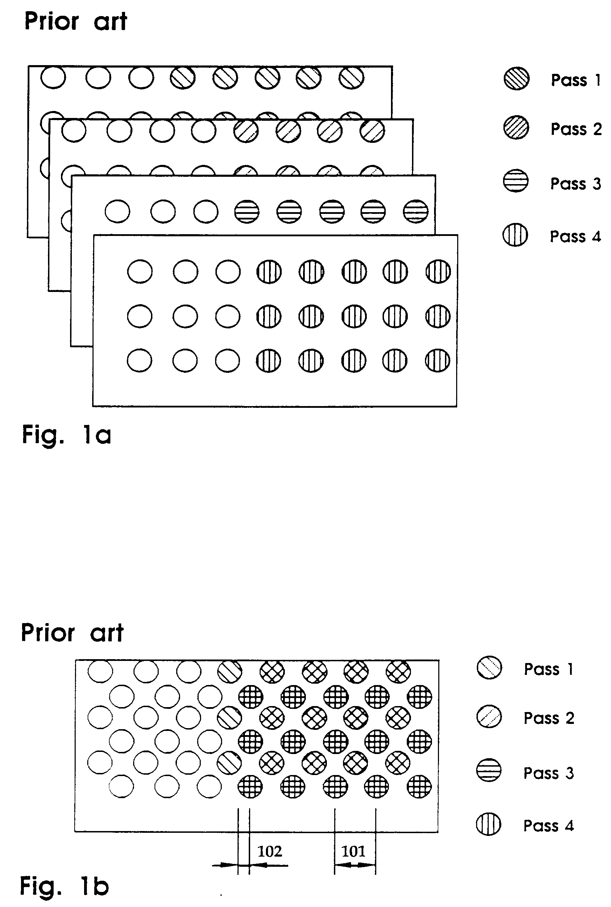

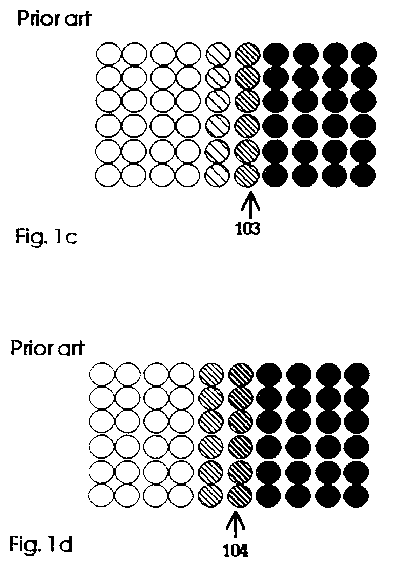

- Fig. 1a bis 1d: Darstellungen bekannter Verfahren;
- Fig. 2a und 2b: Darstellungen von Kantenbereichen von Scan-Zeilen;
- Fig. 3: eine Vorrichtung zur Herstellung einer Struktur bzw. eines Flächenmusters, die ein Ausführungsbeispiel der Erfindung ist;
- Fig. 4a und 4b: Darstellungen von Kantenbereichen von Scan-Zeilen;
- Fig. 5a: ein festes Pixel-Raster;
- Fig. 5b: eine Pixel-Anordnung gemäß eines Ausführungsbeispiels der Erfindung; und
- Fig. 6: ein Ausführungsbeispiel für eine Modulatortreiberlogik, die bei der Ausführungsform der Fig. 3 zur Anwendung kommen kann.

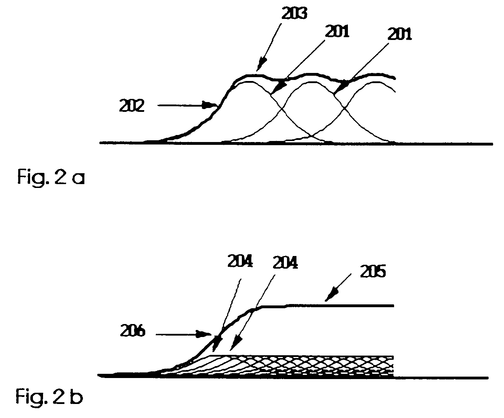

Vor einer detaillierten Erläuterung der Erfindung soll zunächst die Asymmetrie zwischen Kanten in zwei Richtungen einer Rast-Scan-Struktur erläutert werden. Figur 2a zeigt, daß in einem Querschnitt senkrecht zur Scan-Zeile die gesamte Energie auf die Scan-Zeilen 201 zentriert ist mit einer Streuung um jede Scan-Zeile 201. Die Steilheit der Kante 202 einer daraus resultierenden Belichtung 203 ist durch den Verlauf der Streufunktion allein bestimmt. Durch geeignete Wahl des Scan-Zeilenabstandes in Abhängigkeit von der Zeilenstreubreite läßt sich eine gefüllte Struktur mit fast ebener Belichtung erreichen. Das Erfordernis der ebenen und glatten Anfüllung zwischen den Scan-Zeilen bestimmt die Bestrahlungsfleckgröße. Wenn die Bestrahlungsfleckgröße einmal festgelegt ist, ergibt sich keine weitere Verschlechterung der Kantenschärfe.

Wie die Figur 2b zeigt, sind in Richtung entlang der Scan-Zeilen zwei Effekte wirksam, die die Kante weniger scharf machen. Der erste Effekt beruht darauf, daß der Modulator kein idealer Schalter ist, sondern eine endliche Anstiegszeit hat, die eine gewisse Unschärfe bei der Struktur verursacht. Der zweite Effekt ist mehr fundamental. Die Strahlungsenergie wird an den Pixelpunkten nicht blitzartig abgegeben, sondern an den Pixelpunkten ein- und ausgeschaltet. Aus der Figur 2b ist zu ersehen, daß eine große Anzahl an schwachen Zeilenstreufunktionen 204 über den Bereich verstreut ist, über welchen der Strahl eingeschaltet ist. Hierdurch wird eine eben ansteigende integrierte Belichtung 205 erreicht. In einer typischen Raster-Scan-Struktur sind die Kanten 205 in Richtung längs der Scan-Zeilen um 30 % weniger steil als quer zur Scan-Zeile.

Die Kantenschärfe ist ein wichtiger Qualitätsparameter, und sie soll so hoch wie möglich sein. Jedoch ist auch die Symmetrie der Kantenschärfe in X- und Y-Richtung gleichermaßen wichtig. Der lichtempfindliche Überzug und das Chromätzverfahren einer Photomaske besitzen eine Schwellenwerteigenschaft. Diese wirkt sich so aus, daß der Chromfilm intakt bleibt an der Stelle, an welcher die Belichtungsdosis unter dem Schwellenwert liegt, und an der Stelle entfernt wird, an welcher die Belichtungsdosis über diesem Schwellenwert liegt. Eine unterschiedliche Kantensteilheit in den verschiedenen Richtungen verkomplizieren die Verfahrens- und Belichtungsabhängigkeit der Abmessungen in bearbeiteten Mustern noch mehr und erfordern einen erhöhten Kalibrieraufwand und erhöhte Genauigkeit bei der Prozeßsteuerung.

Die X-Y-Asymmetrie könnte man eventuell durch einen elliptischen Brennfleck kompensieren. Eine eingehende Untersuchung zeigt jedoch, daß in einem vorgegebenen System die Anzahl der aufgelösten Punkte entlang der Scan-Zeile ein Systemparameter ist und ein elliptischer Brennfleck, der längs der Scan-Zeile verkürzt ist, zu einer Verkürzung der Scanzeile selbst führt und somit eine verringerte Schreibgeschwindigkeit bewirkt.

Bei der Erfindung wird ein verfeinertes Adressierraster in einer Weise erreicht, die den praktischen und theoretischen obengenannten Beschränkungen optimal angepaßt ist, so daß mit geringem Aufwand an Schreibzeit, Datenvolumen und Kantendefinition ein verdichtetes Raster der Pixel erreicht wird.

Insbesondere kommt bei der Erfindung ein kreisförmiger Brennfleck zur Anwendung, der eine höhere als erforderliche Kantendefinition in Richtung quer zu den Scan-Zeilen gewährleistet. In dieser Richtung ist eine Antialiasing-Interpolation zwischen den Scan-Zeilen eingefügt, die eine Sub-Scan-Zeilenadressierung gewährleistet. Der vorhandene Verlust an Kantendefinition wird aus der überhöhten Kantenschärfe genommen und stellt eine angenäherte Symmetrie zwischen X- und Y-Richtung wieder her.

In Richtung entlang der Scan-Zeilen wird die erhöhte Adressenpunktdichte in der Weise gewährleistet, daß keine Verschlechterung der Kantenschärfe verursacht wird. Hieraus resultiert eine erhöhte Dichte der Pixel (Bildelementpunkte). Das resultierende, äußerst asymmetrische Raster mit wenigstens vierfach höherer Bildelementdichte in Richtung entlang der Scan-Zeilen, zusammen mit einer eindimensionalen Interpolation quer zu den Scan-Zeilen ermöglicht im Vergleich zu herkömmlichen Techniken ein feineres Adressenraster in beiden Richtungen, wobei die Kantendefinition in der schlechtesten Richtung kaum beeinträchtigt ist.

Das Erfordernis einer höheren Modulationsfrequenz tritt nicht auf, da die kleinste Strukturgröße, welche geschrieben werden muß, mit dem Adressenraster nicht schrumpft. Unter dieser Annäherung enthalten die Daten immer Dehnungen mehrerer Adressenpunkte mit konstanter Energie und ein geeignetes verdichtetes Datenformat, d. h. die Runlänge-Codierung verhindert ein Anwachsen des Datenvolumens proportional zur Dichte der Adressenpunkte.

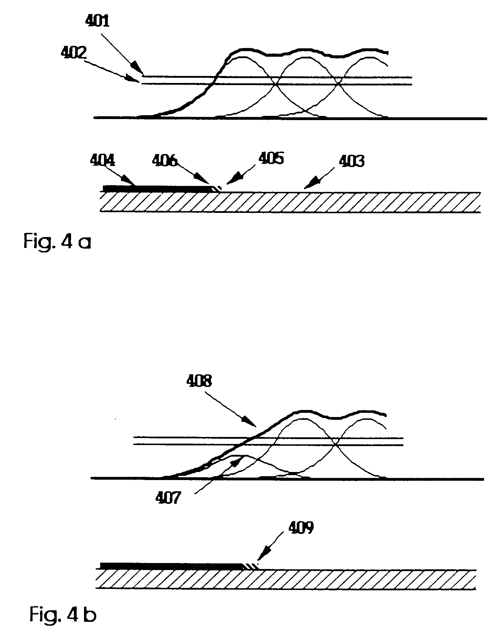

In den Figuren 4a und 4b sind Querschnitte senkrecht zur Längsausdehnung der Scan-Zeilen durch einen Kantenbereich gezeigt. Die Figur 4a zeigt den Querschnitt eines Kantenbereiches ohne Interpolation und die Figur 4b den Kantenbereich mit Interpolation. Moderne photoempfindliche Überzüge besitzen eine äußerst harte Gradation. Sie besitzen einen Dosisschwellenwert, über welchem der lichtempfindliche Überzugsfilm in der Entwicklerlösung beseitigt wird und unterhalb welchem der lichtempfindliche Überzugsfilm unangegriffen bleibt. Die Figuren 4a und 4b zeigen jeweils zwei Linien, eine obere Linie 401 und eine untere Linie 402. Die obere Linie 401 stellt die untere Grenzlinie dar für die vollständige Beseitigung des lichtempfindlichen Überzugsfilms während der Entwicklungsbehandlung, und die untere Linie 402 stellt die obere Grenzlinie dar für die höchste Lichtdosis, bei welcher der Überzugsfilm nicht angegriffen wird. Für Lichtdosierungen zwischen den beiden Linien ist das Ergebnis unsicher und hängt ab von Unterschieden bei der Entwicklerlösungsstärke und -aggressivität sowie von der Überzugsschichtdicke und -empfindlichkeit. Diese Unsicherheitszone überträgt eine Zone von Randrauhigkeit und Merkmalabmessungsänderung 403. Natürlich soll das Belichtungsprofil so steil wie möglich sein. In der Figur 4b ist eine erste Scan-Zeile 404 mit geringerer Dosierung geschrieben, und die Kante 405 ist im Vergleich zur Kante in der Fig. 4a verschoben. Ferner ist die Kante weniger steil, und die Zone der Randrauhigkeit 406 ist etwas breiter. Zur Verdeutlichung ist die Rauhigkeit übertrieben dargestellt, und in Wirklichkeit entspricht die Differenz der Steilheit im Kantenbereich zwischen Figur 4a und 4b etwa der Steilheitsdifferenz zwischen Figur 2a und 2b.

Normalerweise ist die Interpolation an den Kanten der Strukturelemente in den Eingangsdaten nicht enthalten. Sie kann jedoch während der Datenaufbereitung zugefügt werden, obgleich auch der umgekehrte Weg möglich ist.

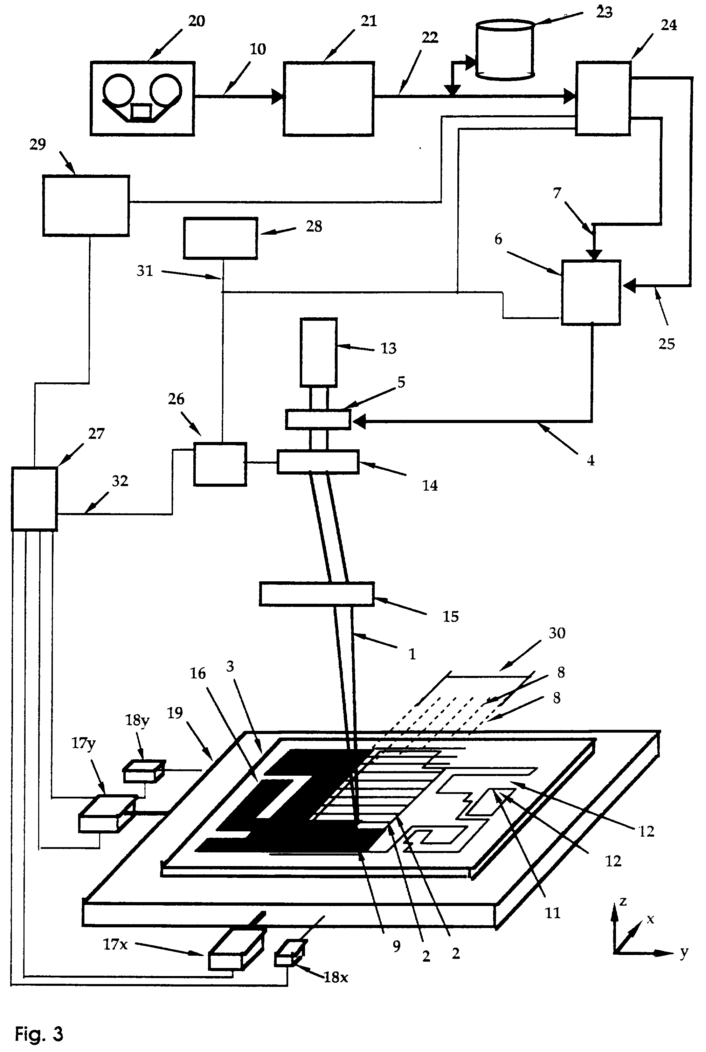

Im folgenden wird die Datenzuführung erläutert. Die Änderungen in dem äquivalenten Pixeldatenstream sind gering, was aus der Annahme bekannt ist, daß eine minimale Strukturgröße bedeutend größer ist als ein Pixel in Scan-Richtung. Hieraus ergeben sich zwei Konsequenzen, erstens, daß die Runlänge-Codierung (RLE) als Speicherformat wirksam ist und zweitens, daß die Hardware nicht so ausgebildet sein muß, daß sie einen beliebigen Bitstream erzeugt. In bevorzugter Weise kommt bei der Erfindung eine Hardware (Figur 3) zum Einsatz, welche Runlänge-codierte Daten direkt verarbeitet, d. h. einen Teil des Energiewerts und eines Dauerbzw. Schalterpositionswertes.

Die wiederholte Ladung von RLE-Datenbestandteilen in eine Modulatortreiberlogik 6 tritt mit einer Rate auf, die normalerweise geringer ist als die Pixelrate. Das Laden der Daten erfolgt im Takt eines Datenliefertaktgebers, der eine Taktgeschwindigkeit hat, die kompatibel ist mit Standard-IC-Familien, z.B. FAST-TTL. Zwei Datenbestandteile können für eine wirkungsvolle Anwendung der zur Verfügung stehenden Bits zu einem Datenwort kombiniert werden. Die Modulatortreiberlogik 6 trennt Leistungs- und Änderungspositionsfelder am Eingang und liefert einer Modulationseinrichtung 5 das Leistungssteuersignal nach einer Zeit, die abgeleitet ist von einem oder beiden letzten Positionsfeldern. Wenn der Datenliefertakt eine Frequenz aufweist, die geringer ist als die Pixelrate, was normalerweise der Fall ist, wird die Verzögerung des Modulatorsteuersignals nicht von einem Zähler erzeugt, sondern es erfolgt bevorzugt eine Auswahl unter den verschiedenen Takt signalen mit Zeitverzögerungen zwischen diesen.

Das Laden eines RLE-Bestandteiles für jeden Taktzyklus bzw. für jede Taktphase bei mehrphasigen Takten des Datenliefertaktes verbietet das Schreiben von Strukturelementen, welche kürzer sind als das Äquivalent eines Taktzyklusses bzw. einer Taktphase.

Die Strahlungsleistung kann entweder durch Modulation der Lichtquelle oder durch Verwendung eines Modulators mit kontinuierlicher Lichtquelle moduliert werden. Es ist auch möglich, eine nichtlineare Beziehung zwischen der Belichtung des äußersten Pixels an der Kante eines Strukturelementes und der Verschiebung dieser Kante durch Verwendung eines Tabellenleseverfahrens oder anderer Korrekturverfahren vorzusehen. Ferner ist es möglich, die Belichtung von mehr als einer Pixel reihe entlang der Kante zu modifizieren, um einen Belichtungsgradienten zu erhalten, der unabhängig von der Position bezüglich der Scan-Zeilen ist.

Im Gegensatz zu dem Mehrfachdurchlaufprinzip, das in der GB-PS 2 215 553 verwendet wird, kommt bei der Erfindung eine variable Belichtung durch Modulation des Strahles auf verschiedene Leistungspegel während eines einzelnen Schreibdurchgangs zur Anwendung. Das Ergebnis ist ein beliebig feines Raster ohne Durchsatzprobleme.

Es ist möglich, die Erfindung in der Weise anzuwenden, daß aufeinanderfolgende Pixel mit unveränderter Leistung geschrieben werden können, ohne daß mehr als ein Steuerwort erzeugt wird.

In der Fig. 3 ist ein Ausführungsbeispiel für eine Vorrichtung dargestellt, mit welcher Strukturen (Flächenmuster) auf lichtempfindlich beschichteten Unterlagen hergestellt werden können. Beim dargestellten Ausführungsbeispiel wird ein Substrat 3 in Form einer Glasplatte verwendet, die mit einem lichtempfindlichen Überzug, beispielsweise einem Photolack, beschichtet ist. Die Glasplatte 3 befindet sich auf einem Objekttisch 19, der in X- und Y-Richtung bewegt werden kann. Ein Schreibkopf mit einer Fokussierungslinse 15 und einer Ablenkeinrichtung 14, die bevorzugt als akustooptische Ablenkeinrichtung ausgebildet ist, ist in den X- und Y-Richtungen stationär angeordnet. Die Fokussierungslinse 15 kann jedoch frei in vertikaler Richtung (Z-Richtung) bewegt werden. Sie befindet sich wenige Mikron über der Oberfläche der Glasplatte 3 auf einem Luftkissen. Da das Luftkissen nur mit dem Gewicht der Fokussierungslinse 15 belastet ist, läßt sich aufgrund der Unabhängigkeit von der Z-Koordinate die Höhe des Luftkissens konstant halten, so daß die Oberfläche der Glasplatte 3 sich immer in der Brennebene befindet, selbst wenn die Oberfläche uneben ist.

Eine Laserstrahlquelle 13 erzeugt einen Laserstrahl, der von einer Modulatoreinrichtung 5, insbesondere akustooptische Modulareinrichtung, im Hinblick auf seine Leistung, insbesondere Intensität, moduliert wird. Die Fokussierungslinse 15 fokussiert den Laserstrahl und bildet einen fokussierten Laserstrahl 1, der auf die Oberfläche des als Glasplatte ausgebildeten Substrats 3 gerichtet ist.

Zur Überwachung der Positionierung des Objekttisches 19 sind Positionsüberwachungseinrichtungen 18x und 18y vorgesehen. Diese überwachen die Positionierung des Objekttisches 19 in der X- und Y-Richtung relativ gegenüber dem Schreibkopf (Ablenkeinrichtung 14 und Fokussierungslinse 15). Sie bilden zusammen mit Elektromotoren 17x und 17y einen Servomechanismus, der die genau gesteuerte Bewegung des Objekttisches 19 bewirkt.

Der in X-Richtung wirkende Servomechanismus bewegt den Objekttisch 19 mit Hilfe des Elektromotors 17x, der bevorzugt als Linearmotor ausgebildet ist, in der X-Richtung mit einer konstanten Geschwindigkeit zur Erzeugung von Streifen 30 mit einer bestimmten Breite beim Scanning des Laserstrahls 1 in den Scan-Zeilen 2. Wenn ein jeweiliger Streifen 30 beendet ist, führt der X-Servomechanismus einen Rückholhub in die Ausgangsposition aus. Anschließend wird der Objekttisch 19 durch den Elektromotor 17y, der bevorzugt als Schrittmotor ausgebildet ist, um eine Streifenbreite in der Y-Richtung bewegt.

Eine Scanning-Schaltung 26 erzeugt ein hochfrequentes Ablenksignal mit linearer Rampenfunktion. Die Scanning-Schaltung 26 ist mit der Ablenkeinrichtung 14 verbunden. Hierdurch wird eine lineare Ablenkung des Laserstrahls 1 in der Breite des jeweiligen Streifens 30 bewirkt. Der Brennpunkt des fokussierten Laserstrahls 1 wird entlang der Scan-Zeilen 2, die senkrecht zur Längsausdehnung der Streifen 30 verläuft, auf der Oberfläche der Glasplatte 3 abgelenkt. Mit 8 sind die Positionen der Pixel in den Scan-Zeilen 2 lediglich schematisch, d.h. nicht maßstabgerecht, bezeichnet.

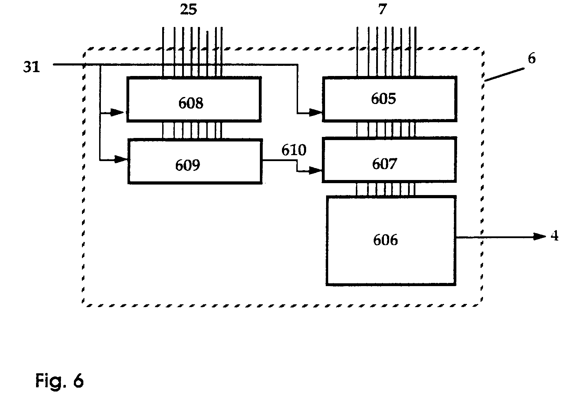

Die Laserstrahlquelle (HeCd) 13 erzeugt den Laserstrahl 1 mit bevorzugter Wellenlänge von 442 nm. Der Laserstrahl wird durch den akustooptischen Modulator 5 geleitet. Dieser wird von einem hochfrequenzten Modulationsantriebssignal 4 angesteuert. Das Modulationsantriebssignal 4 wird von einer Modulatortreiberlogik 6 geliefert. Die Leistung des Modulationsantriebssignals 4 wird von einem analogen Modulationsantriebssignal eines Digital-Analogumsetzers gesteuert. Der Digital-Analogumsetzer, welcher in der Modulatortreiberstufe 6 vorhanden ist (Figur 6), wird von einem Leistungssteuersignal 7 über einen bevorzugt als Register ausgebildeten Speicher gesteuert. Dieser speichert das für die Steuerung erforderliche digitale Leistungssteuerwort.

Die Figur 6 zeigt eine bevorzugte Ausführungsform der in der Figur 3 verwendeten Modulatortreiberlogik. Diese besitzt zwei als Register 605 und 608 ausgebildete Speicher für Bitwörter. Das Register 605 ist mit Leistungsdaten 7, welche von der Datenliefereinrichtung 24 (Figur 3) kommen, geladen. Das Register 608 ist mit Verzögerungsdaten 25, welche ebenfalls von der Datenliefereinrichtung 24 kommen, geladen. Dies erfolgt aufgrund eines vom Taktsignal 31 verursachten Übergangs. Ein Digital-Analogwandler 606 wird dabei noch betrieben von vorher im Speicher 607, gespeicherten Leistungsdaten. Dieser kann ebenfalls als Register ausgebildet sein. Eine digitalgesteuerte Verzögerungsschaltung 609 überträgt das Taktsignal 31 mit Verzögerung auf ihre Ausgangsseite. Die Verzögerung hängt ab von den Daten, die im Register 608 gespeichert sind. Nach dieser Verzögerung wird die aktive Flanke des Taktsignals am Ausgang 610 der Verzögerungsschaltung 609 geliefert. Der im Register 605 gespeicherte Wert wird in das Register 607 geladen und der Eingangsseite des Digital-Analogwandlers 606 zugeführt. Nach der internen Verzögerung im Digital-Analogwandler 606 wird ein neues analoges Leistungsseuersignal 7 am Ausgang der Modulatortreiberstufe der Modulatoreinrichtung 5 zugeleitet.

Das Ausführungsbeispiel der Figur 3, in welcher die dick ausgezogenen Pfeillinien den Fluß der Strukturdaten und die dünn ausgezogenen Linien die Leitungen für die Steuersignale darstellen, enthält ferner die Schreibsteuereinheit 29, welche als Prozessor ausgebildet sein kann. Die Schreibsteuereinheit 29 initiiert das Lesen der Daten aus einem Speicher 23 und sendet Anweisungs- bzw. Befehlssignale an eine XY-Servosteuereinheit 27 für die Bewegungssteuerung des Objekttisches 19. Ein Taktgenerator 28 erzeugt das Taktsignal 31, das den Betrieb der Datenlieferlogik bzw. Datenliefereinrichtung 24, der Modulatortreiberlogik 6 und der Ablenkschaltung 26 synchronisiert. Von der Servosteuereinrichtung 27 wird ferner ein getrenntes Bereitschaftssignal 32 an die Ablenkschaltung 26 geliefert. Dieses Bereitschaftssignal 32 stellt sicher, daß der Betrieb der Ablenkeinrichtung 14 so lange ruht, bis der Objekttisch 19 seine richtige X-Position erreicht. Auf diese Weise wird im Hinblick auf die Ablenkeinrichtung 14 eine genaue Positionierung des Objekttisches 19 erreicht. Da die Modulatoreinrichtung 5 und die Ablenkeinrichtung 14 trägheitsfrei arbeiten und von dem gleichen Taktsignal 31 angetrieben sind, erzielt man eine hohe Positionsgenauigkeit.

Die XY-Servosteuereinheit 27 arbeitet somit zeitabgestimmt mit dem Servosystem (17x, 17y, 18x, 18y) und der Ablenkschaltung 26 zusammen, so daß sichergestellt ist, daß die Scan-Zeilen-Streifen 30, das Scanning in der jeweiligen Streifenbreite durch die Ablenkeinrichtung 14 und die Modulation durch die Modulatoreinrichtung 5 synchron ausgeführt werden. Hierdurch wird gewährleistet, daß der Durchschnittspositionsfehler geringer als 0,05 Mikron, einschließlich der Umwelteinflüsse auf die Laserinterferometer (Positionsüberwachungseinrichtungen 18x und 18y), ist. Beim dargestellten Ausführungsbeispiel besitzt das Positionswort elf Bits, und das Leistungswort besitzt vier Bits. Man kann ein Raster von 0,5 x 0,037 Mikron ohne Antialiasing erzielen. Hieraus ergeben sich Annäherungsfehler, die mit den eingangs beschriebenen Anforderungen kompatibel sind. Die Taktfrequenz beträgt bevorzugt 25 MHz, und die Scanlänge, welche der Breite der Streifen 30 entspricht, beträgt bevorzugt 160 Mikron. Unter Berücksichtigung der Scanning- und Streifenrücklaufhubzeiten beträgt die Schreibgeschwindigkeit vier Quadratmillimeter pro Sekunde mit einem einzelnen Schreibstrahl.

Bei der Erfindung können anstelle des einzelnen Schreibstrahls auch mehrere Schreibstrahlen verwendet werden. Man benötigt dann eine entsprechende Anzahl an Modulatoren, Linsen und parallelen Datenbahnen usw..

Das Positionsfeld enthält ausreichend Daten, um eine absolute Position für eine Leistungsänderung zu berechnen. Das Positionsfeld ist jedoch nicht unbedingt als Absolutposition codiert. Insbesondere im Falle gepaarter Leistungs- und Runlänge-Daten kann die Runlängecodierung ausgeführt sein entweder als ein Abstand, um den Stromwert vor der nächsten Änderung festzuhalten oder als ein Abstand, um den nächsten Stromwert festzuhalten oder als eine Absolutposition, an welcher der nächste Wert beginnt, oder als Absolutposition, an welcher der nächste Wert endet oder als eine andere ausreichende Codierung. Ferner kann das Positionsfeld zwei Unterfelder aufweisen mit einem absolut ausgebildeten Unterfeld und einem anderen relativ ausgebildeten Unterfeld. Anstelle der Modulatoreinrichtung 5 kann auch eine modulierte Lichtquelle, beispielsweise ein Halbleiterlaser oder mehrere Halbleiterlaser, verwendet werden.

Eine Dateneingabeeinrichtung 20 enthält digitale Eingangsdaten für eine auf dem Substrat 3 herzustellende Struktur 9. Diese Daten liegen in Form einer Liste von Strukturelementen 12 bzw. 16 bzw. regelmäßigen Strukturformularen oder Strukturkonstanten vor, so daß die Strukturelemente berechnet werden können. Die Spezifizierung der Belichtung kann auf eine Maximalbelichtung normalisiert sein oder im Falle eines einzelnen Belichtungswertes für alle Muster implizit angenommen werden. In allen Fällen können X- und Y-Längenskalen, der Winkel zwischen den Achsen und die absolute Belichtungsdosis durch die Bedienungsperson von dem, was in den Eingangsdaten spezifiziert ist, modifiziert werden. Es können auch andere Verarbeitungen der Daten durchgeführt werden, beispielsweise Spiegelung, Invsersion, Grauskalenkorrekturen und Vorkompensierungen für Unterätzung oder Näherungswirkungen. Der Liefertakt kann ein Einzelphase- oder Mehrphasentakt sein. Das Laden der RLE(Runlängecodierung)-Dateninhalte kann in einem Register oder auch in zwei oder mehr Registern durchgeführt werden. Die Decodierlogik kann einen Vorabruf oder andere Puffer zur Erhöhung der Betriebsgeschwindigkeit aufweisen.

Zur Erhöhung der Betriebsgeschwindigkeit ist es auch möglich, einen Teil der Datenwege zu vervielfachen, beispielsweise die Modulatortreiberlogik mehrfach vorzusehen, selbst wenn nur ein Laserstrahl zum Einsatz kommt.

Die Relativbewegung zwischen Schreibkopf und Substrat kann dadurch gewonnen werden, daß der Schreibkopf sich gegenüber dem ortsfesten Substrat bewegt oder umgekehrt. Ferner ist es möglich, daß sich der Schreibkopf in eine Richtung und das Substrat in einer senkrechten Richtung dazu bewegt.

Bei dem in der Fig. 3 dargestellten Ausführungsbeispiel werden in der Dateneingabeeinrichtung 20 die geometrischen Eigenschaften der herzustellenden Struktur 9 bzw. Strukturelemente 12, 16 zusammen mit ihrer Belichtung in einem Format 10 das an eine Datenaufbereitungseinrichtung 21 weitergegeben wird, spezifiziert. In der Datenaufbereitungseinrichtung 21 werden die geometrischen Daten in ein verdichtetes Zwischenformat 22 umgewandelt. Dieses verdichtete Zwischenformat 22 wird in eine digitale Speichereinrichtung 23 eingegeben. Ferner wird das verdichtete Zwischenformat einer Datenliefereinrichtung 24 zugeführt, in welcher die gespeicherten Daten in ein internes Datenformat aufbereitet werden. Dieses interne Datenformat besteht aus einem Paar von Dateninhalten 7 und 25, nämlich einem Dateninhalt 7 für die Strahlleistung und einem Dateninhalt 25 für die Position. Dieser Dateninhalt 25 kann, wie schon in Zusammenhang mit Figur 6 erläutert wurde, Verzögerungsdaten beinhalten. Der Dateninhalt 7 für die Strahl leistung wird in Form eines Leistungssteuersignals 7 und der Dateninhalt für die Position in Form eines Positionssignals 25 der Modulatortreiberstufe 6 zugeleitet. Die Modulatortreiberstufe, welche als Logikschaltung ausgebildet ist, ruft diese Daten aus der Datenliefereinrichtung 24 ab. Die Modulatortreiberstufe 6 liefert das Modulationsantriebssignal 4, welches an den in regelmäßigen Abständen entlang der senkrecht zu den Streifen 30 verlaufenden Scan-Zeilen 2 angeordneten Pixelpunkten 8 veränderbar ist. Der Abstand zwischen zwei benachbarten Pixelpunkten 8 längs der Scan-Zeilen 2 ist um einen Faktor von wenigstens 4 kleiner als der Abstand zwischen zwei benachbarten Scan-Zeilen.

Durch die Erfindung läßt sich eine feine Struktur 9, die aus den Strukturelementen 12, 16 zusammengesetzt ist, mit Hilfe des fokussierten Laserstrahls 1 herstellen, dessen Genauigkeit vergleichbar ist mit solchen Strukturen, die mit Hilfe von Elektronenstrahlmaschinen hergestellt sind. Jedoch benötigt man bei der erfindungsgemäßen Vorrichtung einen erheblich geringeren Aufwand als bei Elektronenstrahlmaschinen. Ferner erreicht man eine erhebliche Verbesserung des Adressenrasters dadurch, daß in Längsrichtung der Scan-Zeilen der Abstand zwischen benachbarten Pixelpunkten geringer bemessen wird als der Abstand zwischen benachbarten Scan-Zeilen. Dies führt zu einer Verbesserung der Adressier- bzw. Rasterauflösung mit geringerer Kantenstörung als bei einem Antialiasingschema unter Beibehaltung eines handhabbaren Datenvolumens.

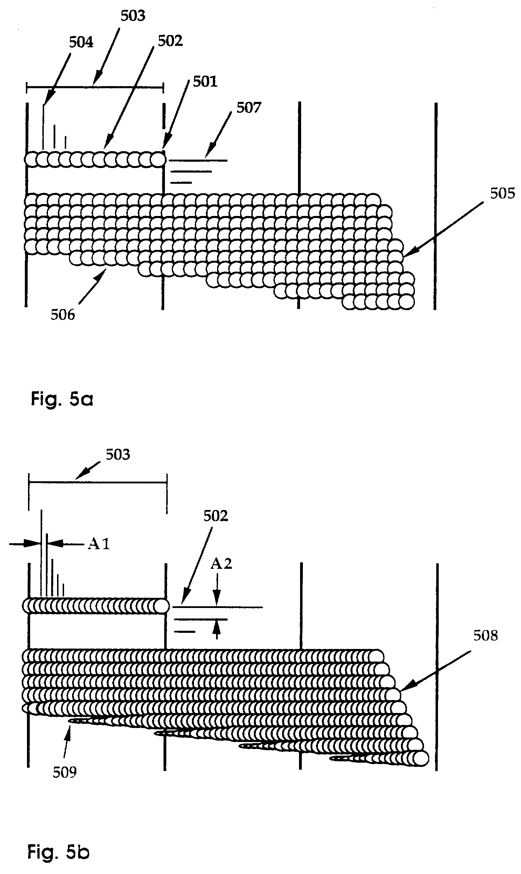

Die Fig. 5a zeigt ein festes Raster mit kleinen Kreisen, welche die beugungsbegrenzte Ausdehnung eines jeden Pixel zeigt. Die Pixel sind auf einem Pixelraster 504 zentriert, und ein Scan-Zeilenstreifen 503 wird durch aufeinanderfolgende Scan-Zeilen 502 gebildet. Die Pixel sind auf der Scan-Zeile 502 zentriert und in gleichen Abständen voneinander angeordnet. Der Pixelabstand und der Abstand aufeinanderfolgender Scan-Zeilen 507 ist gleich groß bemessen. Die Figur zeigt eine belichtete Scan-Zeile 502 und einen mit Pixel angefüllten Bereich, der sich über drei Streifen 503 erstreckt. Dieser Bereich besitzt eine gegenüber der Vertikalen schräg verlaufende Kante 5 und eine gegenüber der Horizontalen schräg verlaufende Kante 506. Bei der dargestellten Struktur ist es nicht möglich, die Kante an fraktionellen Pixelpunkten zu positionieren. Der schräge Kantenverlauf ist daher zackig ausgebildet.

Die Figur 5b zeigt eine erfindungsgemäße Pixelanordnung. Die Pixeldichte entlang der Scan-Zeilen 502 ist höher, und zwar um mindestens das Vierfache höher als in Richtung der Längsausdehnung der Streifen 503 bzw. senkrecht zur Scan-Zeile 502 In der Figur 5b ist dies durch die Abstände A1 und A2 noch verdeutlicht. A1 bedeutet den Abstand der jeweiligen Pixeladressierung in einer Scan-Zeile 502, und der Abstand A2 kennzeichnet den Abstand der jeweiligen Scan-Zeilen 502 von einander. Wie aus der Fig. 5b zu erkennen ist, gewinnt man hierdurch eine äußerst feine Adressierung an der vertikalen Kante. Es läßt sich daher ein relativ glatter Verlauf auch bei einer gegenüber der vertikalen schräg verlaufenden Kante 508 erreichen.

Die bei einem bevorzugten Ausführungsbeispiel der Erfindung in vorteilhafter Weise noch zur Anwendung kommende Leistungsmodulation verbessert auch eine gegenüber der Horizontalen schräg verlaufende Kante 509, wie aus der Fig. 5b eindeutig zu ersehen ist. Es zeigt sich somit, daß man eine äußerst feine Adressierung bei der Erfindung erreicht und außerdem einen glatten Kantenverlauf auch bei schrägen Kanten erreichen kann. Diese Vorteile werden erriecht, obgleich die Schreibzeit sich bei der Ausführungsform der Fig. 5a und der erfindungsgemäßen Ausführungsform der Fig. 5b nicht unterscheide. Mit der Erfindung erreicht man eine Erhöhung der Vielseitigkeit beim Schreiben unterschiedlicher Flächenmuster bzw. Strukturen und eine zusätzliche Freizügigkeit gegenüber dem durch die Scan-Zeilen und den Pixeltakt vorgegebenen diskreten Raster.

## Patentansprüche

1. Verfahren zur Herstellung von Mikrostrukturen auf einem mit einer lichtempfindlichen Schicht beschichteten Substrat mit Hilfe wenigstens eines modulierten und fokussierten Laserstrahls, bei dem Position und Abmessung von fundamentalen Strukturformen in Abhängigkeit von gespeicherten Positions- und Leistungsdaten für Bildelemente gesteuert werden,
dadurch **gekennzeichnet**,
daß die lichtempfindliche Schicht entlang paralleler Scan-Zeilen, die gleiche Abstände voneinander aufweisen, durch wenigstens einen Laserstrahl mit gleichen Abständen voneinander aufweisenden Bildelementen, von denen zwei benachbarte Bildelemente in Richtung einer Scan-Zeile einen Abstand voneinander aufweisen, der um einen Faktor von wenigstens vier kleiner ist als der Abstand zwischen zwei benachbarten Scan-Zeilen, in einem Durchgang belichtet wird, wobei durch Änderung der Leistungspegel des Laserstrahls bei der Belichtung der Bildelemente in dem einen Durchgang eine eindimensionale Interpolation quer zu den Scan-Zeilen gebildet wird.

2. Verfahren nach Anspruch 1, dadurch gekennzeichnet, daß zwei benachbarte Bildelemente in Richtung einer Scan-Zeile einen Abstand voneinander aufweisen, der um einen Faktor von wenigstens fünf kleiner ist als der Abstand zwischen zwei benachbarten Scan-Zeilen.

3. Verfahren nach Anspruch 1 oder 2, dadurch gekennzeichnet, daß zwei benachbarte Bildelemente in Richtung einer Scan-Zeile einen Abstand voneinander aufweisen, der um einen Faktor von wenigstens acht kleiner ist als der Abstand zwischen zwei benachbarten Scan-Zeilen.

4. Verfahren nach einem der Ansprüche 1 bis 3, dadurch gekennzeichnet, daß ein Laserstrahl mit kreisförmigem Brennfleck erzeugt wird.

5. Verfahren nach einem der Ansprüche 1 bis 4, dadurch gekennzeichnet, daß zur Änderung der Leistungspegel des Laserstrahls bei der Belichtung der Bildelemente ein jeweiliges Leistungssteuersignal aus einem gepaarten Datenfeld gebildet wird, das aus den Positions- und Leistungsdaten besteht.

6. Verfahren nach einem der Ansprüche 1 bis 5, dadurch gekennzeichnet, daß die Daten runlänge-codiert werden.

7. Verfahren nach Anspruch 5, dadurch gekennzeichnet, daß zur Bildung des Leistungssteuersignals eine Tabellenlesen-Verschiebung der Daten durchgeführt wird.

8. Verfahren nach Anspruch 7, dadurch gekennzeichnet, daß zur Bildung des Leistungssteuersignals eine Tabellenlesen-Verschiebung der Positionsdaten durchgeführt wird.

9. Verfahren nach einem der Ansprüche 5 bis 8, dadurch gekennzeichnet, daß die Daten für die Bildung des Leistungssteuersignals in regelmäßigen Zeitabständen, welche von einem Datenliefertakt bestimmt werden, geliefert werden.

10. Verfahren nach einem der Ansprüche 5 bis 9, dadurch gekennzeichnet, daß der Abstand, der dem Abstand zwischen der Belichtung zweier benachbarter Bildelemente in einer Scan-Zeile entspricht, geringer bemessen wird als eine Periode des Datenliefertaktes.

11. Verfahren nach einem der Ansprüche 1 bis 11, dadurch gekennzeichnet, daß die Positionsdaten aus einem Taktzyklusfeld zur Steuerung eines Datenliefertaktzyklusses, während welchem die Belichtung der Bildelemente zeitlich festgelegt wird, und einem Taktzyklusunterfeld zur Verzögerung der Belichtung der Bildelemente innerhalb des Datenliefertaktzyklusses zusammengesetzt werden.

12. Verfahren nach einem der Ansprüche 1 bis 11, dadurch gekennzeichnet, daß das Leistungssteuersignal nicht mehr als einmal während eiens Datenliefertaktzyklusses geändert wird.

13. Verfahren nach einem der Ansprüche 1 bis 12, dadurch gekennzeichnet, daß auf das Substrat als lichtempfindliche Schicht Fotolack aufgebracht wird.

14. Verfahren nach einem der Ansprüche 1 bis 13, dadurch gekennzeichnet, daß die parallelen Scan-Zeilen durch wiederholte lineare eindimensionale Ablenkung des fokussierten Laserstrahls und eine geradlinige Relativverschiebung des Substrats gegenüber dem fokussierten Laserstrahl mit konstanter Geschwindigkeit in einer Richtung im wesentlichen senkrecht zur eindimensionalen Ablenkung des Laserstrahls in nebeneinander liegenden Streifen erzeugt werden.

15. Verfahren nach Anspruch 14, dadurch gekennzeichnet, daß die Belichtung der Bildelemente in nebeneinander liegenden Streifen mit einer Überlappung, welche wenigstens einer Periode des Datenliefertaktes entspricht, durchgeführt wird.

16. Vorrichtung zur Herstellung von Mikrostrukturen auf einem mit einer lichtempfindlichen Schicht beschichteten Substrat (3) zur Durchführung eines Verfahrens nach Anspruch 1 mit
- wenigstens einer Laserstrahlquelle (13) zum Aussenden eines Laserstrahls (1);
- einer Modulatoreinrichtung (5) zur Änderung der Leistung des Laserstrahls (1);
- wenigstens einer Fokussiereinrichtung (15) zur Fokussierung des Laserstrahls auf die lichtempfindliche Schicht;
- einer Ablenkeinrichtung (14) zum Ablenken des Laserstrahls (1);
- einer mechanischen Einrichtung (17, 19) zur Bewegung des Substrats (3) relativ gegenüber dem Laserstrahl (1), einer Datenliefereinrichtung (24), welche Leistungsdaten (7) für die Strahlleistung und Positionsdaten für die jeweiligen Positionen von Bildelementen liefert; und
- einer Modulatortreiberlogik (6) zum Abrufen der Daten aus der Datenliefereinrichtung (24) und Steuern der Modulatoreinrichtung (5) in Abhängigkeit von den Leistungsdaten und Positionsdaten,
dadurch gekennzeichnet, daß
- die Modulatortreiberlogik für die Leistungsdaten (7) ein Register (607) und für die Positionsdaten (25) ein Register (609) mit Verzögerungsdaten aufweist und daß über das Register (609) mit den Verzögerungsdaten ein mit der Ablenkeinrichtung (14) und der mechanischen Einrichtung (17, 19) koordiniertes Taktsignal (31) dem Register (607) für die Leistungsdaten (7) bei der Bildung eines der Modulatoreinrichtung (5) zugeführten Leistungssteuersignals (4) zuführbar ist zur Einstellung des Leistungspegels bei der Belichtung des jeweiligen Bildelements.

## Claims

1. A method for producing microstructures on a substrate coated with a photosensitive layer with the aid of at least one modulated and focussed laser beam, wherein the position and dimension of fundamental structural forms are controlled in dependence upon stored position and power data for picture elements,
characterized in that
the photosensitive layer is exposed, with one pass of at least one laser beam along parallel scan lines having equal spacings from each other, to picture elements having equal spacings from each other and of which two adjacent picture elements have a spacing from each other along the direction of a scan line that is smaller by a factor of at least four than the spacing between two adjacent scan lines, wherein by varying the power levels of the laser beam during the exposure of the picture elements in said one pass a one-dimensional interpolation transverse to the scan lines is made.

2. A method according to claim 1, characterized in that two adjacent picture elements have a spacing from each other along the direction of a scan line that is smaller than the spacing between two adjacent scan lines by a factor of at least five.

3. A method acccording to claim 1 or 2, characterized in that two adjacent picture elements have a spacing from each other along the direction of a scan line that is smaller than the spacing between two adjacent scan lines by a factor of at least eight.

4. A method according to any one of claims 1 to 3, characterized in that a laser beam having a circular focal spot is generated.

5. A method according to any one of claims 1 to 4, characterized in that for changing the power level of the laser beam during the exposure of the picture elements, a respective power control signal is formed from a paired data field consisting of the position and power data.

6. A method according to any one of claims 1 to 5, characterized in that the data are run-length encoded.

7. A method according to claim 5, characterized in that for forming the power control signal, a table look-up of the data is performed.

8. A method according to claim 7, characterized in that for forming the power control signal, a table look-up of the position data is performed.

9. A method according to any one of claims 5 to 8, characterized in that the data for forming the power control signal are delivered at regular time intervals determined by a data delivery clock.

10. A method according to any one claims 5 to 9, characterized in that the spacing corresponding to the spacing between the exposure of two adjacent picture elements in one scan line is determined to be smaller than a period of the data delivery clock.

11. A method according to any one of claims 1 to 10, characterized in that the position data are composed of a clock cycle field for controlling a data delivery clock cycle during which the time of exposure of the picture elements is fixed, and a clock cycle subfield for delaying the exposure of the picture elements within the data delivery clock cycle.

12. A method according to any one of claims 1 to 11, characterized in that the power control signal is changed not more than once during a data delivery clock cycle.

13. A method according to any of claims 1 to 12, characterized in that a photoresist is coated onto the substrate as a photosensitive layer.

14. A method according to any one of claims 1 to 13, characterized in that the parallel scan lines are produced by repeated linear one-dimensional deflection of the focussed laser beam and a linear relative displacement of the substrate with respect to the focussed laser beam with constant speed in a direction substantially perpendicular to the one-dimensional deflection of the laser beam in mutually juxtaposed stripes.

15. A method according to claim 14, characterized in that the exposure of the picture elements in mutually juxtaposed stripes is performed with an overlap corresponding to at least one period of the data delivery clock.

16. An apparatus for producing microstructures on a substrate (3) coated with a photosensitive layer, for performing a method of claim 1, including
- at least one laser beam source (13) for emitting a laser beam (1);
- a modulator means (5) for changing the power of the laser beam (1);
- at least one focussing means (15) for focussing the laser beam onto the photosensitive layer;
- a deflecting means (14) for deflecting the laser beam (1);
- a mechanical means (17, 19) for moving the substrate (3) relative to the laser beam (1), a data delivery means 24 for delivering power data (7) for the beam power and position data for the respective positions of picture elements; and
- a modulator drive logic (6) for calling up data from the data delivery means (24) and controlling the modulator means (5) in dependence upon the power data and position data,
characterized in that
- the modulator drive logic has a register (607) for the power data (7) and a register (609) having delay data for the position data (25), and that a clock signal (31) coordinated with the deflecting means (14) and the mechanical means (17, 19) can be delivered through the register (609) having the delay data to the register (607) for the power data (7) during the production of a power control signal (4) delivered to the modulator means (5), for adjusting the power level during the exposure of the respective picture element.

## Revendications

1. Procédé de production de microstructures sur un substrat revêtu d'une couche photosensible, à l'aide d'au moins un faisceau laser modulé et focalisé, dans lequel la position et la dimension de formes de structure fondamentales sont commandées en fonction de données mémorisées de position et de puissance pour des éléments d'image,
caractérisé en ce que
la couche photosensible est exposée en un seul passage, le long de lignes de balayage parallèles également espacées, par au moins un faisceau laser, avec des éléments d'image également espacés dont deux voisins ont dans la direction d'une ligne de balayage un espacement au moins quatre fois plus petit que l'espacement de deux lignes de balayage voisines, une interpolation unidimensionnelle étant formée perpendiculairement aux lignes de balayage par modification du niveau de puissance du faisceau laser lors de l'exposition des éléments d'image dans le passage.

2. Procédé selon la revendication 1, caractérisé en ce que deux éléments d'image voisins ont dans la direction d'une ligne de balayage un espacement au moins cinq fois plus petit que la distance entre deux lignes de balayage voisines.

3. Procédé selon l'une des revendications 1 et 2, caractérisé en ce que deux éléments d'image voisins ont dans la direction d'une ligne de balayage un espacement au moins huit fois plus petit que la distance entre deux lignes de balayage voisines.

4. Procédé selon l'une des revendications 1 à 3, caractérisé en ce qu'il est produit un faisceau laser à tache focale circulaire.

5. Procédé selon l'une des revendications 1 à 4, caractérisé en ce que pour la modification du niveau de puissance du faisceau laser lors de l'exposition des éléments d'image, un signal de commande de puissance est formé à partir d'un champ de données appariées constitué de données de position et de puissance.

6. Procédé selon l'une des revendications 1 à 5, caractérisé en ce que les données sont codées par longueur de suite.

7. Procédé selon la revendication 5, caractérisé en ce que pour la formation du signal de commande de puissance est exécutée une translation de données, par lecture de table.

8. Procédé selon la revendication 7, caractérisé en ce que pour la formation du signal de commande de puissance est exécutée une translation de données de position, par lecture de table.

9. Procédé selon l'une des revendications 5 à 8, caractérisé en ce que les données pour la formation du signal de commande de puissance sont fournies à des intervalles de temps réguliers qui sont déterminés par un cycle de fourniture de données.

10. Procédé selon l'une des revendications 5 à 9, caractérisé en ce que l'intervalle de temps qui correspond à l'espacement entre les expositions de deux éléments d'image voisins sur une ligne de balayage est choisie plus petite qu'une période du rythme de fourniture de données.

11. Procédé selon l'une des revendications 1 à 10, caractérisé en ce que les données de position sont composées d'un champ de cycle d'horloge pour la commande d'un cycle d'horloge de fourniture de données pendant lequel est fixée temporellement l'exposition des éléments d'image, et d'un sous-champ de cycles d'horloge pour le retardement de l'exposition des éléments d'image à l'intérieur du cycle d'horloge de fourniture de données.

12. Procédé selon l'une des revendications 1 à 11, caractérisé en ce que le signal de commande de puissance n'est pas modifié plus d'une fois pendant un cycle d'horloge de fourniture de données.

13. Procédé selon l'une des revendications 1 à 12, caractérisé en ce que sur le substrat est appliqué comme couche photosensible un vernis photosensible.

14. Procédé selon l'une des revendications 1 à 13, caractérisé en ce que les lignes de balayage parallèles sont produites par déviation unidimensionnelle linéaire répétée du faisceau laser focalisé et par un déplacement relatif rectiligne du substrat par rapport au faisceau laser focalisé à une vitesse constante dans une direction sensiblement perpendiculaire à la déviation unidimensionnelle du faisceau laser dans des bandes situées les unes à côté des autres.

15. Procédé selon la revendication 14, caractérisé en ce que l'exposition des éléments d'image est effectuée dans des bandes situées les unes à côté des autres avec un chevauchement correspondant au moins à une période du rythme de fourniture de données.

16. Appareil pour la production de microstructures sur un substrat (3) revêtu d'une couche photosensible, pour la mise en oeuvre d'un procédé selon la revendication 1, comportant
- au moins une source de faisceau laser (13) pour l'émission d'un faisceau laser (1),
- un dispositif modulateur (5) pour la modification de la puissance du faisceau laser (1),
- au moins un dispositif de focalisation (15) pour la focalisation du faisceau laser sur la couche photosensible,
- un dispositif de déviation (14) pour la déviation du faisceau laser (1),
- un dispositif mécanique (17, 19) pour le déplacement du substrat (3) par rapport au faisceau laser (1), un dispositif de fourniture de données (24) qui fournit des données de puissance (7) pour la puissance du faisceau et des données de position pour les positions respectives des éléments d'image, et
- une logique d'attaque de modulateur (6) pour l'appel des données dans le dispositif de fourniture de données (24) et la commande du dispositif modulateur (5) en fonction des données de puissance et des données de position,
caractérisé en ce que
- la logique d'attaque de modulateur présente un registre (607) pour les données de puissance (7) et un registre (609) à données de retard pour les données de position (25) et qu'un signal de cycle (31) coordonné avec le dispositif de déviation (14) et avec le dispositif mécanique (17, 19) peut être envoyé par l'intermédiaire du registre (609) à données de retard au registre (607) pour les données de puissance (7) lors de la formation d'un signal de commande de puissance (4) envoyé au dispositif modulateur (5), pour le réglage du niveau de puissance lors de l'exposition de l'élément d'image correspondant.
